(19) **Europäisches Patentamt**
**European Patent Office**
**Office européen des brevets**

(11) **EP 4 628 916 A1**

(12) **EUROPEAN PATENT APPLICATION**
published in accordance with Art. 153(4) EPC

(43) Date of publication:
08.10.2025 Bulletin 2025/41

(21) Application number: 24894397.9

(22) Date of filing: 25.10.2024

(51) International Patent Classification (IPC):
*G01R 31/396* (2019.01)  *G01R 31/382* (2019.01)
*G01R 31/392* (2019.01)

(52) Cooperative Patent Classification (CPC):
**G01R 31/382; G01R 31/392; G01R 31/396**

(86) International application number:
**PCT/KR2024/016376**

(87) International publication number:
**WO 2025/110503 (30.05.2025 Gazette 2025/22)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: 20.11.2023 KR 20230159979

(71) Applicant: **LG Energy Solution, Ltd.**
**Seoul 07335 (KR)**

(72) Inventors:
• **KIM, Jinsu**
**Daejeon 34122 (KR)**
• **KOO, Jinwoo**
**Daejeon 34122 (KR)**

(74) Representative: **Plasseraud IP**
**104 Rue de Richelieu**
**CS92104**
**75080 Paris Cedex 02 (FR)**

(54) **BATTERY DIAGNOSIS DEVICE AND METHOD**

(57) Disclosed is a battery diagnosis apparatus which includes at least one processor; and a memory configured to store at least one instruction executed by the at least one processor. Here, the at least one instruction may include an instruction to collect cycle-by-cycle battery capacity which is calculated during a charge-/discharge cycle of the battery; an instruction to define a capacity threshold range for a current charge/discharge cycle based on battery capacities for a plurality of predetermined cycles; and an instruction to determine whether the battery is abnormal based on whether the capacity for the current charge/discharge cycle of the battery is within the capacity threshold range.

[Figure 3]

**Description**

[Technical Field]

This application claims priority to and the benefit of Korean Patent Application No.10-2023-0159979 filed in the Korean Intellectual Property Office on November 20, 2023, the entire contents of which are incorporated herein by reference.

The present invention relates to a battery diagnosis apparatus and method, and more particularly, to a battery diagnosis apparatus and method for diagnosing whether a battery is abnormal based on battery capacity per cycle collected during charge/discharge cycles of the battery.

[Background Art]

Secondary batteries, capable of recharging and reuse, may be used as an energy source for small devices such as mobile phones, tablet PCs and vacuum cleaners, and also used as an energy source for medium and large devices such as automobiles and an energy storage system (ESS) for smart grids.

Secondary batteries may be applied to a system in a form of an assembly such as a battery module in which a plurality of battery cells is connected in series and parallel or a battery rack in which battery modules are connected in series and parallel according to system requirements. For medium and large-sized devices, a high-capacity battery system with multiple battery modules connected in parallel may be applied to satisfy required capacity of the device.

During a manufacturing process of the battery cell, various tests for safety, performance, defects, etc. may be conducted. Specifically, safety tests such as overcurrent tests, high-temperature storage tests, short-circuit tests, and penetration tests may be performed to evaluate safety due to defects that may occur during operation of the battery.

In addition, long-term charge/discharge tests may be performed to evaluate performance in the case of long-term use of the battery. For example, a charge/discharge test device may collect discharge capacity for each charge/discharge cycle, calculate a slope of the discharge capacity, and then detect battery cells that have deteriorated performance or are at risk of deterioration based on the calculated slope.

However, in the case of such charge/discharge test methods, since abnormal batteries are detected based only on the slope of the discharge capacity, the diagnosis accuracy is low and the misdiagnosis rate is high.

Therefore, as a technology that can solve these problems, an appropriate diagnosis technology is needed that can detect abnormal battery performance early and more accurately.

[Detailed Description of the Invention]

[Technical Problem]

To obviate one or more problems of the related art, embodiments of the present disclosure provide a battery diagnosis apparatus for diagnosing whether a battery is abnormal based on battery capacity per cycle collected during charge/discharge cycles of the battery.

To obviate one or more problems of the related art, embodiments of the present disclosure also provide a battery diagnosing method by the battery diagnosis apparatus.

[Technical Solution]

In order to achieve the objective of the present disclosure, a battery diagnosis apparatus may include at least one processor; and a memory configured to store at least one instruction executed by the at least one processor.

Here, the at least one instruction may include an instruction to collect cycle-by-cycle battery capacity which is calculated during a charge/discharge cycle of the battery; an instruction to define a capacity threshold range for a current charge/discharge cycle based on battery capacities for a plurality of predetermined cycles; and an instruction to determine whether the battery is abnormal based on whether the capacity for the current charge/discharge cycle of the battery is within the capacity threshold range.

The instruction to collect cycle-by-cycle battery capacity may include an instruction to collect cycle-by-cycle discharge capacity of the battery.

The instruction to define the capacity threshold range for a current charge/discharge cycle may include an instruction to define the capacity threshold range for the current charge/discharge cycle based on the battery capacities for the most recent N (N is a natural number greater than or equal to 3) charge/discharge cycles.

The instruction to define the capacity threshold range for a current charge/discharge cycle may include an instruction to calculate a capacity decrease rate based on battery capacities of previous cycles; an instruction to calculate a predicted minimum value and a predicted maximum value for the capacity of the current cycle based on the capacity decrease rate; and an instruction to define the capacity threshold range based on the predicted minimum value and the predicted maximum value.

The instruction to calculate the capacity decrease rate may include an instruction to calculate the capacity decrease rate based on a difference value between the largest battery capacity and the smallest battery capacity among the battery capacities of the most recent N (N is a natural number greater than or equal to 3) cycles.

The instruction to calculate the predicted minimum value and the predicted maximum value for the capacity of the current cycle may include an instruction to predict the minimum value of capacity decrease amount based on the capacities of the most recent M (M is a natural number greater than or equal to 1 and less than N) cycles among the most recent N (N is a natural number greater than or equal to 3) cycles and the capacity decrease rate; an instruction to predict the maximum value of the capacity decrease amount based on the capacities of the early progressed L (L is a natural number greater than or equal to 1 and less than N) cycles among the N cycles and the capacity decrease rate; and an instruction to calculate the predicted minimum value and the predicted maximum value based on the minimum value and the maximum value of the capacity decrease amount.

The instruction to calculate the predicted minimum value and the predicted maximum value for the capacity of the current cycle may include an instruction to calculate the predicted minimum value by subtracting the maximum value of the capacity decrease amount from an average value or a median value of the capacities of the M cycles; and an instruction to calculate the predicted maximum value by subtracting the minimum value of the capacity decrease amount from an average value or a median value of the capacities of the L cycles.

The instruction to determine whether the battery is abnormal may include an instruction to classify the battery as an abnormal battery, if the capacity for the current charge/discharge cycle is out of the capacity threshold range.

The instruction to define the capacity threshold range may include an instruction to sequentially update the capacity threshold range as charge/discharge cycles for the battery are sequentially performed. Here, the instruction to determine whether the battery is abnormal includes an instruction to determine whether the battery is abnormal based on the sequentially updated capacity threshold range.

According to another embodiment of the present disclosure, a battery diagnosis method may include a step of collecting cycle-by-cycle battery capacity which is calculated during a charge/discharge cycle of the battery; a step of defining a capacity threshold range for a current charge/discharge cycle based on battery capacities for a plurality of predetermined cycles; and a step of determining whether the battery is abnormal based on whether the capacity for the current charge/discharge cycle of the battery is within the capacity threshold range.

The step of collecting cycle-by-cycle battery capacity includes: a step of collecting cycle-by-cycle discharge capacity of the battery.

The step of defining the capacity threshold range for a current charge/discharge cycle may include a step of defining the capacity threshold range for the current charge/discharge cycle based on the battery capacities for the most recent N (N is a natural number greater than or equal to 3) charge/discharge cycles.

The step of defining the capacity threshold range for a current charge/discharge cycle may include a step of calculating a capacity decrease rate based on battery capacities of previous cycles; a step of calculating a predicted minimum value and a predicted maximum value for the capacity of the current cycle based on the capacity decrease rate; and a step of defining the capacity threshold range based on the predicted minimum value and the predicted maximum value.

The step of calculating the capacity decrease rate may include a step of calculating the capacity decrease rate based on a difference value between the largest battery capacity and the smallest battery capacity among the battery capacities of the most recent N (N is a natural number greater than or equal to 3) cycles.

The step of calculating the predicted minimum value and the predicted maximum value for the capacity of the current cycle may include a step of predicting the minimum value of capacity decrease amount based on the capacities of the most recent M (M is a natural number greater than or equal to 1 and less than N) cycles among the most recent N (N is a natural number greater than or equal to 3) cycles and the capacity decrease rate; a step of predicting the maximum value of the capacity decrease amount based on the capacities of the early progressed L (L is a natural number greater than or equal to 1 and less than N) cycles among the N cycles and the capacity decrease rate; and a step of calculating the predicted minimum value and the predicted maximum value based on the minimum value and the maximum value of the capacity decrease amount.

The step of calculating the predicted minimum value and the predicted maximum value for the capacity of the current cycle may include a step of calculating the predicted minimum value by subtracting the maximum value of the capacity decrease amount from an average value or a median value of the capacities of the M cycles; and a step of calculating the predicted maximum value by subtracting the minimum value of the capacity decrease amount from an average value or a median value of the capacities of the L cycles.

The step of determining whether the battery is abnormal may include a step of classifying the battery as an abnormal battery, if the capacity for the current charge/discharge cycle is out of the capacity threshold range.

The step of defining the capacity threshold range includes a step of sequentially updating the capacity threshold range as charge/discharge cycles for the battery are sequentially performed. Here, the step of determining whether the battery is abnormal includes a step of determining whether the battery is abnormal based on the sequentially updated capacity threshold range.

[Advantageous Effects]

According to embodiments of the present disclosure, it is possible to detect performance abnormalities of the battery early and make more accurate judgments by defining a capacity threshold range based on battery capacity for each of a plurality of charge/discharge cycles, and then diagnosing whether the battery is abnormal based on whether a current battery capacity is included within the capacity threshold range.

[Brief Description of the Drawings]

FIG. 1 is an operational flowchart of a general battery diagnosis method.
FIG. 2 is a block diagram showing a battery diagnosis system according to embodiments of the present invention.
FIG. 3 is an operational flowchart of a battery diagnosis method according to embodiments of the present invention.
FIG. 4 is a reference diagram for explaining a battery diagnosis method according to embodiments of the present invention.
FIG. 5 is an operational flowchart of a method for defining a capacity threshold range according to embodiments of the present invention.
FIG. 6 is a reference diagram for explaining a method for defining a capacity threshold range according to embodiments of the present invention.
FIG. 7 is a block diagram of a battery diagnosis apparatus according to embodiments of the present invention.
10: battery
100: battery assembly
200, 700: battery diagnosis apparatus

[Best Modes for Practicing the Disclosure]

The present invention may be modified in various forms and have various embodiments, and specific embodiments thereof are shown by way of example in the drawings and will be described in detail below. It should be understood, however, that there is no intent to limit the present invention to the specific embodiments, but on the contrary, the present invention is to cover all modifications, equivalents, and alternatives falling within the spirit and technical scope of the present invention. Like reference numerals refer to like elements throughout the description of the figures.

It will be understood that, although the terms such as first, second, A, B, and the like may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes combinations of a plurality of associated listed items or any of the plurality of associated listed items.

It will be understood that when an element is referred to as being "coupled" or "connected" to another element, it may be directly coupled or connected to the other element or an intervening element may be present. In contrast, when an element is referred to as being "directly coupled" or "directly connected" to another element, there is no intervening element present.

The terms used herein is for the purpose of describing specific embodiments only and are not intended to limit the present invention. As used herein, the singular forms "a", "an" and "the" are intended to include the plural forms as well, unless the context clearly indicates otherwise. It will be further understood that the terms "comprises", "comprising", "includes", "including" and/or "having", when used herein, specify the presence of stated features, integers, steps, operations, constitutional elements, components and/or combinations thereof, but do not preclude the presence or addition of one or more other features, integers, steps, operations, constitutional elements, components, and/or combinations thereof.

Unless otherwise defined, all terms used herein, including technical and scientific terms, have the same meanings as commonly understood by one skilled in the art to which the present invention belongs. It will be further understood that terms, such as those defined in commonly used dictionaries, should be interpreted as having meanings that are consistent with their meanings in the context of the relevant art and will not be interpreted in an idealized or overly formal sense unless expressly so defined herein.

Some terms used herein are defined as follows.

State of Charge (SOC) refers to a current state of charge of a battery, represented in percent points [%], and State of Health (SOH) may be a current condition of a battery compared to its ideal or original conditions, represented in percent points [%].

A battery cell is a basic unit that serves to store power and a battery module refers to an assembly in which a plurality of battery cells are electrically connected.

A battery rack refers to a system of a single structure which is assembled by connecting module units set by a battery manufacturer in series/parallel and may be monitored and controlled by a battery management apparatus/system (BMS). A battery rack may include several battery modules and a battery protection unit or any other protection device. Here, the battery module may also be referred to as a battery pack depending on a device or system in which the battery is used.

A battery bank refers to a group of large-scale battery rack systems configured by connecting a plurality of battery racks in parallel. A bank BMS for a battery bank may monitor and control several rack BMSs, each of which manages a battery rack.

A battery assembly may include a plurality of electrically connected battery cells, and refers to an assembly that functions as a power supply source by being applied to a specific system or device. Here, the battery assembly may mean a battery module, a battery pack, a battery rack, or a battery bank, but the scope of the present invention is not limited to these entities.

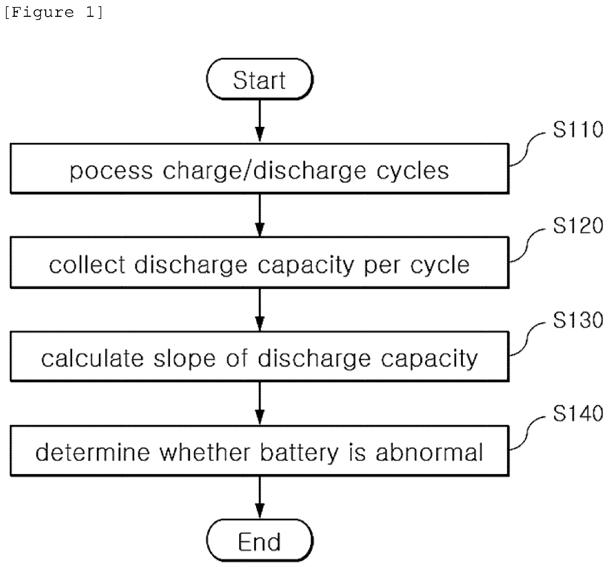

FIG. 1 is an operational flowchart of a general battery diagnosis method.

A general battery diagnosis method may be performed by a battery diagnosis system that performs a long-term charge/discharge test on a battery to diagnose whether the battery is abnormal.

The charge/discharge device included in the battery diagnosis system performs charge/discharge cycles of the battery (S110).

The battery diagnosis device included in the battery diagnosis system collects discharge capacity per cycle which is calculated during the charge/discharge cycle of the battery (S120).

Thereafter, the battery diagnosis apparatus calculates a slope of discharge capacity based on the collected discharge capacity per cycle (S130). Here, the slope of the discharge capacity may be calculated based on a difference value between a discharge capacity in the first cycle and a discharge capacity in the second cycle.

The battery diagnosis apparatus may determine whether the battery is abnormal in performance using the calculated discharge capacity slope (S140). For example, if the discharge capacity in a specific cycle is less than a predetermined threshold capacity and the slope of the discharge capacity is less than a predetermined threshold slope, the battery diagnosis apparatus may classify the battery as a battery with abnormal performance.

In the case of these general battery diagnosis methods, since abnormal batteries are detected based only on an absolute value of discharge capacity and the slope of discharge capacity, the diagnosis accuracy is low and the misdiagnosis rate is high.

The present invention is presented to solve these problems, and various embodiments of the present invention will be described in detail below, with reference to the attached drawings.

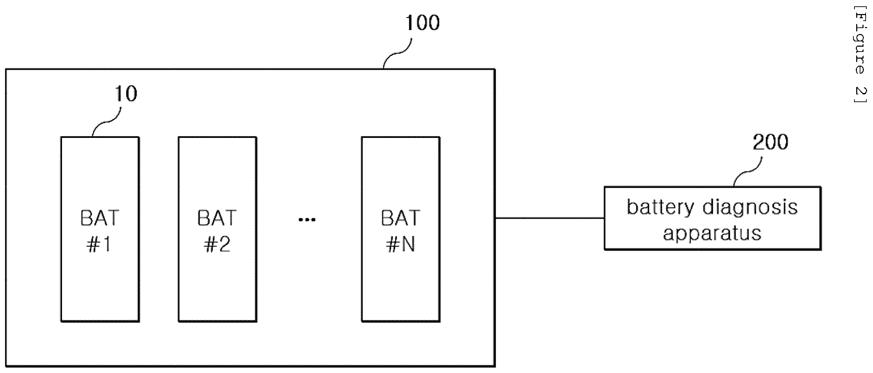

FIG. 2 is a block diagram showing a battery diagnosis system according to embodiments of the present invention.

Referring to FIG. 2, the battery diagnosis system may include a battery assembly 100 configured to include a plurality of batteries 10 (BAT #1 to BAT #N) and a battery diagnosis apparatus 200.

The battery diagnosis system according to embodiments of the present invention may be implemented by being included in a long-term charge/discharge test system, but the scope of the present invention is not limited to these entities. In other words, the battery system according to embodiments of the present invention may be applied to a specific device and may operate to detect an abnormal battery by performing a battery diagnosis method described below.

The plurality of batteries 10 may be electrically connected and included in the battery assembly 100.

The battery 10 according to embodiments of the present invention refers to a battery module or a battery pack, but the scope of the present invention is not limited thereto. That is, the battery system according to embodiments of the present invention may operate to detect an entity in which a performance abnormality has occurred by performing the battery diagnosis method described below on a battery cell, a battery rack, or a battery pack.

The battery diagnosis apparatus 200 may be connected to a state measurement device that senses or calculates state information of the battery assembly 100.

The state measurement device may collect state data such as temperature, current, and voltage values of the battery during processes of the battery charge/discharge cycle. In addition, the state measurement device may calculate battery capacity per cycle using a predetermined battery capacity calculation algorithm during processes of the battery charge/discharge cycle. Here, the battery capacity may correspond to charge capacity or discharge capacity of the battery.

The state measurement device may transmit the battery state data and the battery capacity per cycle collected during the process of the battery charge/discharge cycle to the battery diagnosis apparatus 200. Meanwhile, the battery diagnosis apparatus may be configured to directly calculate the battery capacity based on the state data transmitted from the state measurement device.

The battery diagnosis apparatus 200 may determine whether the battery performance is abnormal based on the battery capacity per cycle. Specifically, the battery diagnosis apparatus 200 may determine whether the battery performance is abnormal, based on whether the battery capacity per charge/discharge cycle falls within a threshold capacity range per cycle. Here, the cycle-by-cycle threshold capacity range may be defined based on battery capacities for a plurality of predetermined cycles, and may be updated each time a charge/discharge cycle is performed.

The battery diagnosis apparatus 200 may determine whether the battery is abnormal for each charge/discharge cycle based on the cycle-by-cycle threshold capacity range that is sequentially updated. Here, if the battery capacity is outside the threshold capacity range for the cycle, the battery diagnosis apparatus 200 may classify the battery as an abnormal battery.

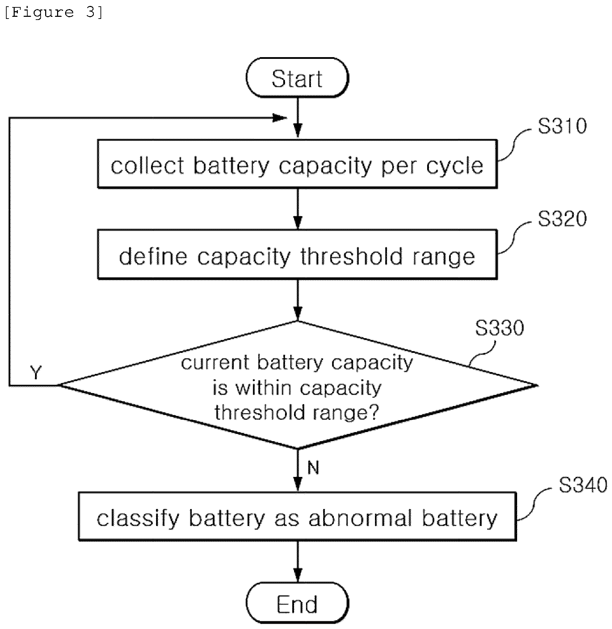

FIG. 3 is an operational flowchart of a battery diagnosis method according to embodiments of the present invention.

The battery diagnosis method according to embodiments of the present invention may be performed by a battery diagnosis apparatus included in a battery diagnosis system.

The battery diagnosis apparatus may collect battery capacity per cycle, which is calculated during a charge/discharge cycle of the battery (S310). Here, the battery diagnosis apparatus may receive battery capacity per cycle from a state measurement device that collects battery state information. Alternatively, the battery diagnosis apparatus may calculate battery capacity per cycle based on state data per cycle transmitted from the state measurement device.

In the embodiments, the battery diagnosis apparatus may collect discharge capacity per cycle. In other words, the battery diagnosis apparatus may determine whether the battery has a performance abnormality based on discharge capacity per cycle.

The battery diagnosis apparatus may define a capacity threshold range for the current charge/discharge cycle based on battery capacities for a plurality of predetermined cycles (S320). Here, the battery diagnosis apparatus may define a capacity threshold range for the current charge/discharge cycle based on the battery capacities for the recent N (N is a natural number greater than or equal to 3) charge/discharge cycles. For example, the capacity threshold range for the current charge/discharge cycle (T-th cycle) may be defined based on discharge capacity of each of the recent 5 cycles ((T-5)th cycle ~ (T-1)th cycle). Meanwhile, N may be predefined as an appropriate number in consideration of diagnosis accuracy.

The battery diagnosis apparatus may calculate a predicted minimum value and a predicted maximum value for the capacity of the current cycle based on the battery capacities of the previous cycles and define the capacity threshold range for the current charge/discharge cycle based on the calculated predicted minimum value and predicted maximum value. For example, if the predicted minimum value is calculated as C1[Ah] and the predicted maximum value is calculated as C2[Ah], the capacity threshold range may be defined as [C1 or more and C2 or less].

The battery diagnosis apparatus may determine whether the battery is abnormal based on whether the battery capacity of the current charge/discharge cycle (the T-th cycle) is within the capacity threshold range defined in S320 (S330).

If the battery capacity is outside the capacity threshold range for the cycle (N of S330), the battery diagnosis apparatus may classify the battery as an abnormal battery.

If the battery capacity is within the capacity threshold range for the cycle (Y of S330), the battery diagnosis apparatus may perform diagnosis for the next charge/discharge cycle. In other words, the battery diagnosis apparatus may update the capacity threshold range for the (T+1)-th cycle and compare the updated capacity threshold range with the battery capacity of the (T+1)-th cycle to determine whether the battery is abnormal.

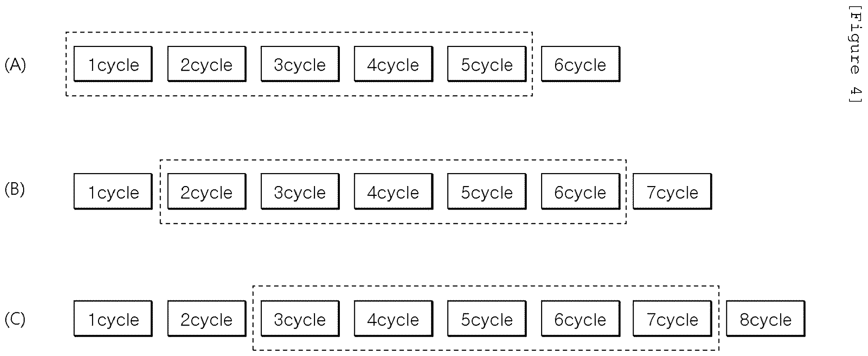

FIG. 4 is a reference diagram for explaining a battery diagnosis method according to embodiments of the present invention. Hereinafter, an example of a battery diagnosis method by a battery diagnosis apparatus will be explained with reference to FIG. 4.

The battery diagnosis apparatus may sequentially collect discharge capacities for each cycle when the charge/discharge cycle of the battery is sequentially performed.

The battery diagnosis apparatus may define a capacity threshold range for the current charge/discharge cycle based on the battery capacity for the most recent N cycles. For example, the battery diagnosis apparatus may define a capacity threshold range for the 6th cycle based on the discharge capacities for each of the 1st to 5th cycles as shown in (A) of FIG. 4. Here, the battery diagnosis apparatus may calculate a predicted minimum value and a predicted maximum value for the capacity of the 6th cycle based on the discharge capacities for each of the 1st to 5th cycles, and define a capacity threshold range for the 6th cycle based on the calculated predicted minimum value and predicted maximum value. For example, if the predicted minimum value is calculated as C1[Ah] and the predicted maximum value is calculated as C2[Ah], the capacity threshold range may be defined as [C1 or more and C2 or less].

The battery diagnosis apparatus may determine whether the battery is abnormal based on whether the battery capacity of the 6th cycle is within the capacity threshold range defined for the 6th cycle. If the battery capacity of the 6th cycle is outside the capacity threshold range for the 6th cycle, the battery may be classified as an abnormal battery.

If the battery capacity of the 6th cycle is within the capacity threshold range for the 6th cycle, the battery diagnosis apparatus may perform a diagnosis process for the 7th cycle.

In other words, the battery diagnosis apparatus may update a capacity threshold range for the 7th cycle based on discharge capacities for each of the 2nd to 6th cycles, as illustrated in (B) of FIG. 4. Here, the battery diagnosis apparatus may calculate the predicted minimum value and predicted maximum value for the capacity of the 7th cycle based on the discharge capacities for each of the 2nd to 6th cycles, and update the capacity threshold range for the 7th cycle based on the calculated predicted minimum value and predicted maximum value. For example, if the predicted minimum value is calculated as C3[Ah] and the predicted maximum value is calculated as C4 [Ah], the capacity threshold range may be updated to [C3 or more and C4 or less].

If the battery capacity for the 7th cycle is outside the capacity threshold range for the 7th cycle, the battery may be classified as an abnormal battery. If the battery capacity for the 7th cycle is within the capacity threshold range for the 7th cycle, the battery diagnosis apparatus may perform a diagnosis process for the 8th cycle.

In other words, the battery diagnosis apparatus may update a capacity threshold range for the 8th cycle based on the discharge capacities for each of the 3rd to 7th cycles, as shown in (C) of FIG. 4. Here, the battery diagnosis apparatus may calculate the predicted minimum value and predicted maximum value for the capacity of the 8th cycle based on the discharge capacities for each of the 3rd to 7th cycles, and update the capacity threshold range for the 8th cycle based on the calculated predicted minimum value and predicted maximum value. For example, if the predicted minimum value is calculated as C5[Ah] and the predicted maximum value is calculated as C6[Ah], the capacity threshold range may be updated to [C5 or more and C6 or less].

The battery diagnosis apparatus may determine whether the battery is abnormal by comparing the battery capacity for the 8th cycle with the capacity threshold range for the 8th cycle. Thereafter, the battery diagnosis apparatus may sequentially update the capacity threshold range for each cycle as described above and perform the diagnosis process.

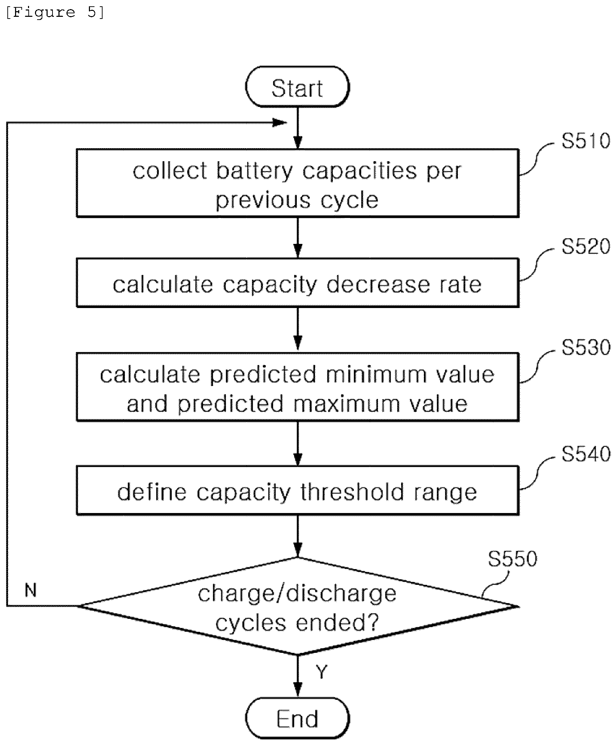

FIG. 5 is an operational flowchart of a method for defining a capacity threshold range according to embodiments of the present invention. Hereinafter, a method for defining a capacity threshold range for a current charge/discharge cycle (Tth cycle) is described.

The battery diagnosis apparatus may collect battery capacities for each of the previous cycles (S510). Here, the battery diagnosis apparatus may collect battery capacities for each of the recent N charge/discharge cycles (T-Nth cycle to T-1th cycle).

Thereafter, the battery diagnosis apparatus may calculate a capacity decrease rate based on the collected battery capacities (S520).

In an embodiment, the battery diagnosis apparatus may calculate the capacity decrease rate based on a difference value between the capacity of the earliest cycle (T-Nth cycle) and the most recently performed cycle (T-1th cycle) among the recent N cycles.

Here, the battery diagnosis apparatus may calculate the capacity decrease rate (R_fall) based on the following equation 1.

[Equation 1]

$$R\_fall = \frac{Cap_{(T-N)} - Cap_{(T-1)}}{Cap_{(T-N)}}$$

(Here, Cap (X) is battery capacity for the Xth cycle)

In another embodiment, the battery diagnosis apparatus may calculate the capacity decrease rate based on a difference value between the largest battery capacity and the smallest battery capacity among the battery capacities of the recent N cycles.

Here, the battery diagnosis apparatus may calculate the capacity decrease rate (R_fall) based on the following equation 2.

[Equation 2]

$$R\_fall = \frac{Cap_{max} - Cap_{min}}{Cap_{max}}$$

(Here, $Cap_{max}$ is the largest battery capacity among the battery capacities of the recent N cycles, and $Cap_{min}$ is the smallest battery capacity among the battery capacities of the recent N cycles.)

The battery diagnosis apparatus may calculate a predicted minimum value and a predicted maximum value for the capacity of the current cycle (the Tth cycle) based on the calculated capacity decrease rate in S520 (S530). Here, the battery diagnosis apparatus may calculate the predicted minimum value and the predicted maximum value based on a predicted value for capacity decrease amount in the current cycle (the Tth cycle).

More specifically, the battery diagnosis apparatus may predict the minimum value of the capacity decrease amount based on the capacities and a capacity decrease rate of the M cycles that have recently been performed (M is a natural number greater than or equal to 1 and less than N) among the recent N cycles, and may predict the maximum value of the capacity decrease amount based on the capacities and a capacity decrease rate of the L cycles that have been performed first (L is a natural number greater than or equal to 1 and less than N) among the N cycles. Meanwhile, M and L may be predefined as appropriate numbers in consideration of diagnosis accuracy.

In embodiments, the minimum value of the capacity decrease amount may be calculated as a value obtained by multiplying an average value or median value of the battery capacities of each of the M cycles that have recently been performed (M is a natural number greater than or equal to 2 and less than N) by the capacity decrease rate. Here, the battery diagnosis apparatus may calculate the minimum value (fall_min) of the capacity decrease amount based on the following equation 3.

[Equation 3]

$$fall_{min} = \frac{\sum_{(T-M)}^{(T-1)} Cap(X)}{M} * R\_fall$$

In the embodiments, the maximum value of the capacity decrease amount may be calculated as a value obtained by multiplying an average or median value of the battery capacities of each of the L cycles (L is a natural number greater than or equal to 2 and less than or equal to N) that have been performed first by the capacity decrease rate. Here, the battery diagnosis apparatus may calculate the maximum value (fall_max) of the capacity decrease amount based on equation 4 below.

[Equation 4]

$$fall_{max} = \frac{\sum_{(T-N)}^{(T-N+L-1)} Cap(X)}{M} * R\_fall$$

The battery diagnosis apparatus may calculate the predicted minimum value and predicted maximum value for the capacity of the current cycle (the Tth cycle) based on the minimum value (fall_min) and maximum value (fall_max) of the predicted capacity decrease.

In the embodiment, the battery diagnosis apparatus may calculate the predicted minimum value for the capacity of the current cycle (the Tth cycle) by subtracting the maximum value (fall_max) of the capacity decrease amount from the average value or median value of battery capacities of each of the M cycles that have recently been performed (M is a natural number greater than or equal to 2 and less than or equal to N). Here, the battery diagnosis apparatus may calculate the predicted minimum value (Cap_pre_min) for the capacity of the current cycle (the Tth cycle) based on equation 5 below.

[Equation 5]

$$Cap_{pre_{min}} = \frac{\sum_{(T-M)}^{(T-1)} Cap(X)}{M} - fall_{max}$$

In the embodiment, the battery diagnosis apparatus may calculate the predicted maximum value for the capacity of the current cycle (the Tth cycle) by subtracting the minimum value (fall_min) of the capacity decrease amount from the average value or the median value of battery capacities of each of the L cycles (L is a natural number greater than or equal to 2 and less than or equal to N) that have been performed first. Here, the battery diagnosis apparatus may calculate the predicted maximum value (Cap_pre_max) for the capacity of the current cycle (the Tth cycle) based on equation 6 below.
[Equation 6]

$$Cap_{pre_{max}} = \frac{\sum_{(T-N)}^{(T-N+L-1)} Cap(X)}{M} - fall_{min}$$

The battery diagnosis apparatus may define the capacity threshold range for the current cycle (the Tth cycle) based on the predicted minimum value (Cap_pre_min) and the predicted maximum value (Cap_pre_max) calculated in S530 (S540). Here, the capacity threshold range may be defined as greater than or equal to the predicted minimum value (Cap_pre_min) and less than or equal to the predicted maximum value (Cap_pre_max).
The battery diagnosis apparatus may check whether the charge/discharge cycles have ended (S550), and if not ended (N of S550), define a capacity threshold range for the T+1th cycle.

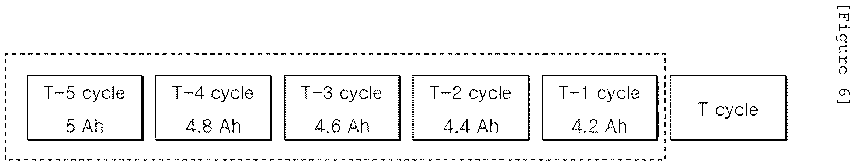

FIG. 6 is a reference diagram for explaining a method for defining a capacity threshold range according to embodiments of the present invention. Hereinafter, an example of a method for defining a capacity threshold range will be explained with reference to FIG. 6.
The battery diagnosis apparatus may define a capacity threshold range for the current cycle (the T-th cycle) based on the battery capacities for each of the recent N charge/discharge cycles (the T-Nth cycle to the T-1th cycle). For example, as illustrated in FIG. 6, the battery diagnosis apparatus may define a capacity threshold range for the current cycle (the T-th cycle) based on the discharge capacities (5, 4.8, 4.6, 4.4, 4.2) for each of the recent five cycles.
First, the battery diagnosis apparatus may calculate a capacity decrease rate (R_fall) based on the recent five battery capacities. Here, the capacity decrease rate (R_fall) may be calculated as 0.16 according to the equation 2 above.
Thereafter, the battery diagnosis apparatus may calculate the minimum value (fall_min) of the capacity decrease amount based on capacities and capacity decrease rate of the M cycles that have recently been performed, and calculate the maximum value (fall_max) of the capacity decrease amount based on capacities and capacity decrease rate of the L cycles that have been performed first. Here, the minimum value (fall_min) of the capacity decrease amount may be calculated as 0.688 according to the equation 3, and the maximum value (fall_max) of the capacity decrease amount may be calculated as 0.784 according to equation 4.
Thereafter, the battery diagnosis apparatus may calculate the predicted minimum value (Cap_pre_min) and the predicted maximum value (Cap_pre_max) of the capacity of the current cycle (the Tth cycle) based on the minimum value (fall_min) of the capacity decrease amount and the maximum value (fall_max) of the capacity decrease. Here, the predicted minimum value (Cap_pre_min) may be calculated as 3.516 according to the above equation 5, and the predicted maximum value (Cap_pre_max) may be calculated as 4.212 according to the above equation 6.
The battery diagnosis apparatus may define the capacity threshold range for the current cycle (Tth cycle) as 3.516 or more and 4.212 or less based on the calculated predicted minimum value (Cap_pre_min) and predicted maximum value (Cap_pre_max).
The battery diagnosis apparatus may determine whether the battery is abnormal based on whether the battery capacity of the current charge/discharge cycle (Tth cycle) is within the capacity threshold range (3.516 or more and 4.212 or less). If the battery capacity of the current charge/discharge cycle is outside the capacity threshold range, the battery is classified as an abnormal battery, whereas the battery diagnosis apparatus may define the capacity threshold range for the (T+1)th cycle if the battery capacity of the current charge/discharge cycle is within the capacity threshold range.

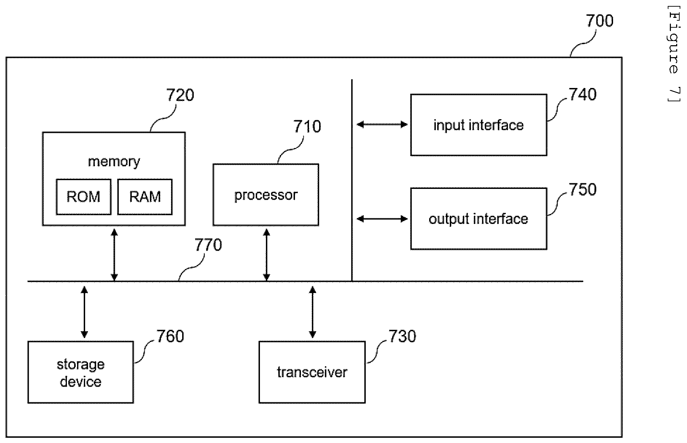

FIG. 7 is a block diagram of a battery diagnosis apparatus according to embodiments of the present invention.

The battery diagnosis apparatus 700 according to embodiments of the present invention may be included in a long-term charge/discharge test system.

The battery diagnosis apparatus 700 may include at least one processor 710, a memory 720 that stores at least one instruction executed by the processor, and a transceiver 730 connected to a network to perform communication.

The at least one instruction may include an instruction to collect cycle-by-cycle battery capacity which is calculated during a charge/discharge cycle of the battery; an instruction to define a capacity threshold range for a current charge/discharge cycle based on battery capacities for a plurality of predetermined cycles; and an instruction to determine whether the battery is abnormal based on whether the capacity for the current charge/discharge cycle of the battery is within the capacity threshold range.

The instruction to collect cycle-by-cycle battery capacity may include an instruction to collect cycle-by-cycle discharge capacity of the battery.

The instruction to define the capacity threshold range for a current charge/discharge cycle may include an instruction to define the capacity threshold range for the current charge/discharge cycle based on the battery capacities for the most recent N (N is a natural number greater than or equal to 3) charge/discharge cycles.

The instruction to define the capacity threshold range for a current charge/discharge cycle may include an instruction to calculate a capacity decrease rate based on battery capacities of previous cycles; an instruction to calculate a predicted minimum value and a predicted maximum value for the capacity of the current cycle based on the capacity decrease rate; and an instruction to define the capacity threshold range based on the predicted minimum value and the predicted maximum value.

The instruction to calculate the capacity decrease rate may include an instruction to calculate the capacity decrease rate based on a difference rate of the capacity of the earliest cycle and the most recently performed cycle among the recent N (N is a natural number greater than or equal to 3) cycles.

The instruction to calculate the predicted minimum value and the predicted maximum value for the capacity of the current cycle may include an instruction to predict the minimum value of capacity decrease amount based on the capacities of the most recent M (M is a natural number greater than or equal to 1 and less than N) cycles among the most recent N (N is a natural number greater than or equal to 3) cycles and the capacity decrease rate; an instruction to predict the maximum value of the capacity decrease amount based on the capacities of the early progressed L (L is a natural number greater than or equal to 1 and less than N) cycles among the N cycles and the capacity decrease rate; and an instruction to calculate the predicted minimum value and the predicted maximum value based on the minimum value and the maximum value of the capacity decrease amount.

The instruction to calculate the predicted minimum value and the predicted maximum value for the capacity of the current cycle may include an instruction to calculate the predicted minimum value by subtracting the maximum value of the capacity decrease amount from an average value or a median value of the capacities of the M cycles; and an instruction to calculate the predicted maximum value by subtracting the minimum value of the capacity decrease amount from an average value or a median value of the capacities of the L cycles.

The instruction to determine whether the battery is abnormal may include an instruction to classify the battery as an abnormal battery, if the capacity for the current charge/discharge cycle is out of the capacity threshold range.

The instruction to define the capacity threshold range may include an instruction to sequentially update the capacity threshold range as charge/discharge cycles for the battery are sequentially performed. The instruction to determine whether the battery is abnormal includes an instruction to determine whether the battery is abnormal based on the sequentially updated capacity threshold range.

The battery diagnosis apparatus 700 may further include an input interface 740, an output interface 750, a storage device 760, and the like. Respective components included in the battery diagnosis apparatus 700 may be connected by a bus 770 to communicate with each other.

Here, the processor 710 may mean a central processing unit (CPU), a graphics processing unit (GPU), or a dedicated processor on which methods according to embodiments of the present invention are performed. The memory (or storage device) may include at least one of a volatile storage medium and a non-volatile storage medium. For example, the memory may include at least one of read only memory (ROM) and random access memory (RAM).

The operations of the method according to the embodiments of the present invention may be implemented as a computer-readable program or code on a computer-readable recording medium. The computer-readable recording medium includes all types of recording devices in which data readable by a computer system is stored. In addition, the computer-readable recording medium may be distributed in a network-connected computer system to store and execute computer-readable programs or codes in a distributed manner.

Although some aspects of the invention have been described in the context of the apparatus, it may also represent a description according to a corresponding method, wherein a block or apparatus corresponds to a method step or feature of a method step. Similarly, aspects described in the context of a method may also represent a feature of a corresponding block or item or a corresponding apparatus. Some or all of the method steps may be performed by (or using) a hardware device, such as, for example, a microprocessor, a programmable computer, or an electronic circuit. In some embodiments, one or more of the most important method steps may be performed by such an apparatus.

In the forgoing, the present invention has been described with reference to the exemplary embodiment of the present invention, but those skilled in the art may appreciate that the present invention may be variously corrected and changed within the range without departing from the spirit and the area of the present invention described in the appending claims.

**Claims**

1. A battery diagnosis apparatus comprising:

   at least one processor; and
   a memory configured to store at least one instruction executed by the at least one processor,
   wherein the at least one instruction includes:

   an instruction to collect cycle-by-cycle battery capacity which is calculated during a charge/discharge cycle of a battery;
   an instruction to define a capacity threshold range for a current charge/discharge cycle based on battery capacities for a plurality of predetermined cycles; and
   an instruction to determine whether the battery is abnormal based on whether the capacity for the current charge/discharge cycle of the battery is within the capacity threshold range.

2. The battery diagnosis apparatus of claim 1, wherein the instruction to collect cycle-by-cycle battery capacity includes: an instruction to collect cycle-by-cycle discharge capacity of the battery.

3. The battery diagnosis apparatus of claim 1, wherein the instruction to define the capacity threshold range for a current charge/discharge cycle includes:
   an instruction to define the capacity threshold range for the current charge/discharge cycle based on the battery capacities for the most recent N charge/discharge cycles, wherein N is a natural number greater than or equal to 3.

4. The battery diagnosis apparatus of claim 1, wherein the instruction to define the capacity threshold range for a current charge/discharge cycle includes:

   an instruction to calculate a capacity decrease rate based on battery capacities of previous cycles;
   an instruction to calculate a predicted minimum value and a predicted maximum value for the capacity of the current charge/discharge cycle based on the capacity decrease rate; and
   an instruction to define the capacity threshold range based on the predicted minimum value and the predicted maximum value.

5. The battery diagnosis apparatus of claim 4, wherein the instruction to calculate the capacity decrease rate includes:
   an instruction to calculate the capacity decrease rate based on a difference value between the largest battery capacity and the smallest battery capacity among the battery capacities of the most recent N cycles, wherein N is a natural number greater than or equal to 3.

6. The battery diagnosis apparatus of claim 4, wherein the instruction to calculate the predicted minimum value and the predicted maximum value for the capacity of the current charge/discharge cycle includes:

   an instruction to predict a minimum value of capacity decrease amount based on the capacities of the most recent M cycles among the most recent N cycles and the capacity decrease rate, wherein N is a natural number greater than or equal to 3, and M is a natural number greater than or equal to 1 and less than N;
   an instruction to predict a maximum value of the capacity decrease amount based on the capacities of the early progressed L cycles among the N cycles and the capacity decrease rate, wherein L is a natural number greater than or equal to 1 and less than N; and
   an instruction to calculate the predicted minimum value and the predicted maximum value based on the minimum value and the maximum value of the capacity decrease amount.

7. The battery diagnosis apparatus of claim 6, wherein the instruction to calculate the predicted minimum value and the predicted maximum value for the capacity of the current charge/discharge cycle includes:

an instruction to calculate the predicted minimum value by subtracting the maximum value of the capacity decrease amount from an average value or a median value of the capacities of the M cycles; and
an instruction to calculate the predicted maximum value by subtracting the minimum value of the capacity decrease amount from an average value or a median value of the capacities of the L cycles.

8. The battery diagnosis apparatus of claim 1, wherein the instruction to determine whether the battery is abnormal includes:
an instruction to classify the battery as an abnormal battery, if the capacity for the current charge/discharge cycle is out of the capacity threshold range.

9. The battery diagnosis apparatus of claim 3, wherein the instruction to define the capacity threshold range includes an instruction to sequentially update the capacity threshold range as charge/discharge cycles for the battery are sequentially performed, and
wherein the instruction to determine whether the battery is abnormal includes an instruction to determine whether the battery is abnormal based on the sequentially updated capacity threshold range.

10. A battery diagnosis method comprising:

a step of collecting cycle-by-cycle battery capacity which is calculated during a charge/discharge cycle of a battery;
a step of defining a capacity threshold range for a current charge/discharge cycle based on battery capacities for a plurality of predetermined cycles; and
a step of determining whether the battery is abnormal based on whether the capacity for the current charge/-discharge cycle of the battery is within the capacity threshold range.

11. The battery diagnosis method of claim 10, wherein the step of collecting cycle-by-cycle battery capacity includes:
a step of collecting cycle-by-cycle discharge capacity of the battery.

12. The battery diagnosis method of claim 10, wherein the step of defining the capacity threshold range for a current charge/discharge cycle includes:
a step of defining the capacity threshold range for the current charge/discharge cycle based on the battery capacities for the most recent N charge/discharge cycles, wherein N is a natural number greater than or equal to 3.

13. The battery diagnosis method of claim 10, wherein the step of defining the capacity threshold range for a current charge/discharge cycle includes:

a step of calculating a capacity decrease rate based on battery capacities of previous cycles;
a step of calculating a predicted minimum value and a predicted maximum value for the capacity of the current charge/discharge cycle based on the capacity decrease rate; and
a step of defining the capacity threshold range based on the predicted minimum value and the predicted maximum value.

14. The battery diagnosis method of claim 13, wherein the step of calculating the capacity decrease rate includes:
a step of calculating the capacity decrease rate based on a difference value between the largest battery capacity and the smallest battery capacity among the battery capacities of the most recent N cycles, wherein N is a natural number greater than or equal to 3.

15. The battery diagnosis method of claim 13, wherein the step of calculating the predicted minimum value and the predicted maximum value for the capacity of the current charge/discharge cycle includes:

a step of predicting a minimum value of capacity decrease amount based on the capacities of the most recent M cycles among the most recent N cycles and the capacity decrease rate, wherein N is a natural number greater than or equal to 3, and M is a natural number greater than or equal to 1 and less than N;
a step of predicting a maximum value of the capacity decrease amount based on the capacities of the early progressed L cycles among the N cycles and the capacity decrease rate, wherein L is a natural number greater than or equal to 1 and less than N; and
a step of calculating the predicted minimum value and the predicted maximum value based on the minimum value and the maximum value of the capacity decrease amount.

**16.** The battery diagnosis method of claim 15, wherein the step of calculating the predicted minimum value and the predicted maximum value for the capacity of the current charge/discharge cycle includes:

a step of calculating the predicted minimum value by subtracting the maximum value of the capacity decrease amount from an average value or a median value of the capacities of the M cycles; and
a step of calculating the predicted maximum value by subtracting the minimum value of the capacity decrease amount from an average value or a median value of the capacities of the L cycles.

**17.** The battery diagnosis method of claim 10, wherein the step of determining whether the battery is abnormal includes:
a step of classifying the battery as an abnormal battery, if the capacity for the current charge/discharge cycle is out of the capacity threshold range.

**18.** The battery diagnosis method of claim 12, wherein the step of defining the capacity threshold range includes a step of sequentially updating the capacity threshold range as charge/discharge cycles for the battery are sequentially performed, and
wherein the step of determining whether the battery is abnormal includes a step of determining whether the battery is abnormal based on the sequentially updated capacity threshold range.

[Figure 1]

```
                    ┌─────────┐
                    │  Start  │
                    └────┬────┘
                         │
                         ▼
   ┌─────────────────────────────────────────────┐      S110
   │       pocess charge/discharge cycles         │
   └──────────────────────┬──────────────────────┘
                          │
                          ▼
   ┌─────────────────────────────────────────────┐      S120
   │       collect discharge capacity per cycle   │
   └──────────────────────┬──────────────────────┘
                          │
                          ▼
   ┌─────────────────────────────────────────────┐      S130
   │       calculate slope of discharge capacity  │
   └──────────────────────┬──────────────────────┘
                          │
                          ▼
   ┌─────────────────────────────────────────────┐      S140
   │       determine whether battery is abnormal  │
   └──────────────────────┬──────────────────────┘
                          │
                          ▼
                    ┌─────────┐
                    │   End   │
                    └─────────┘
```

[Figure 2]

[Figure 3]

```
                        ┌─────────┐
                        │  Start  │
                        └────┬────┘
                             │
        ┌───────────────────►│                      ┌─ S310
        │    ┌────────────────▼─────────────────────┐
        │    │   collect battery capacity per cycle  │
        │    └────────────────┬─────────────────────┘
        │                     │                      ┌─ S320
        │    ┌────────────────▼─────────────────────┐
        │    │    define capacity threshold range    │
        │    └────────────────┬─────────────────────┘
        │                     │              S330
        │              ◇──────▼──────◇
        │  Y      ╱  current battery capacity  ╲
        └────────◇      is within capacity      ◇
                  ╲      threshold range?       ╱
                   ◇──────────┬──────────◇
                              │ N
                              │                      ┌─ S340
             ┌────────────────▼─────────────────────┐
             │  classify battery as abnormal battery │
             └────────────────┬─────────────────────┘
                              │
                        ┌─────▼─────┐
                        │    End    │
                        └───────────┘
```

[Figure 4]

(A)

| 1cycle | 2cycle | 3cycle | 4cycle | 5cycle | 6cycle |

(B)

| 1cycle | 2cycle | 3cycle | 4cycle | 5cycle | 6cycle | 7cycle |

(C)

| 1cycle | 2cycle | 3cycle | 4cycle | 5cycle | 6cycle | 7cycle | 8cycle |

[Figure 5]

[Figure 6]

[Figure 7]

## INTERNATIONAL SEARCH REPORT

| International application No. |
| --- |
| **PCT/KR2024/016376** |

**A. CLASSIFICATION OF SUBJECT MATTER**

**G01R 31/396**(2019.01)i; **G01R 31/382**(2019.01)i; **G01R 31/392**(2019.01)i

According to International Patent Classification (IPC) or to both national classification and IPC

**B. FIELDS SEARCHED**

Minimum documentation searched (classification system followed by classification symbols)

G01R 31/396(2019.01); B60L 58/12(2019.01); G01R 19/00(2006.01); G01R 31/36(2006.01); G01R 31/367(2019.01); G01R 31/392(2019.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 배터리(battery), 진단(diagnostic), 장치(device), 충방전(charge/discharge), 사이클(cycle), 용량(capacity), 범위(range), 이상(abnormality)

**C. DOCUMENTS CONSIDERED TO BE RELEVANT**

| Category* | Citation of document, with indication, where appropriate, of the relevant passages | Relevant to claim No. |
| --- | --- | --- |
| A | KR 10-2020-0140093 A (SAMSUNG SDI CO., LTD. et al.) 15 December 2020 (2020-12-15)<br>See paragraphs [0041], [0051] and [0083]; and figure 3. | 1-18 |
| A | KR 10-2023-0078543 A (LG ENERGY SOLUTION, LTD.) 02 June 2023 (2023-06-02)<br>See paragraphs [0002], [0019] and [0096]-[0097]; and figure 5. | 1-18 |
| A | KR 10-2023-0107066 A (LG ENERGY SOLUTION, LTD.) 14 July 2023 (2023-07-14)<br>See paragraphs [0066]-[0078]; and figure 7. | 1-18 |
| A | KR 10-2021-0031628 A (SAMSUNG ELECTRONICS CO., LTD.) 22 March 2021 (2021-03-22)<br>See paragraphs [0013] and [0089]-[0101]; and figure 7. | 1-18 |
| A | KR 10-1792975 B1 (KOREA UNIVERSITY OF TECHNOLOGY AND EDUCATION INDUSTRY-UNIVERSITY COOPERATION FOUNDATION) 02 November 2017 (2017-11-02)<br>See paragraphs [0049]-[0059]; and figure 4. | 1-18 |

☐ Further documents are listed in the continuation of Box C.   ☑ See patent family annex.

| | |
| --- | --- |
| \* Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **10 February 2025** | **10 February 2025** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

## INTERNATIONAL SEARCH REPORT
### Information on patent family members

International application No.

**PCT/KR2024/016376**

| Patent document cited in search report | | | Publication date (day/month/year) | Patent family member(s) | | | Publication date (day/month/year) |
|---|---|---|---|---|---|---|---|
| KR | 10-2020-0140093 | A | 15 December 2020 | EP | 3748380 | A1 | 09 December 2020 |
| | | | | EP | 3748380 | B1 | 04 May 2022 |
| | | | | HU | E059979 | T2 | 28 January 2023 |
| | | | | KR | 10-2731011 | B1 | 19 November 2024 |
| | | | | PL | 3748380 | T3 | 20 June 2022 |
| | | | | US | 11293987 | B2 | 05 April 2022 |
| | | | | US | 2020-0386819 | A1 | 10 December 2020 |
| KR | 10-2023-0078543 | A | 02 June 2023 | CN | 117355760 | A | 05 January 2024 |
| | | | | EP | 4343349 | A1 | 27 March 2024 |
| | | | | JP | 2024-507499 | A | 20 February 2024 |
| | | | | JP | 7556618 | B2 | 26 September 2024 |
| | | | | US | 2024-0272227 | A1 | 15 August 2024 |
| | | | | WO | 2023-096335 | A1 | 01 June 2023 |
| KR | 10-2023-0107066 | A | 14 July 2023 | CN | 118284817 | A | 02 July 2024 |
| | | | | EP | 4425198 | A1 | 04 September 2024 |
| | | | | WO | 2023-132520 | A1 | 13 July 2023 |
| KR | 10-2021-0031628 | A | 22 March 2021 | US | 11543460 | B2 | 03 January 2023 |
| | | | | US | 2021-0080509 | A1 | 18 March 2021 |
| | | | | WO | 2021-049905 | A1 | 18 March 2021 |
| KR | 10-1792975 | B1 | 02 November 2017 | US | 10254349 | B2 | 09 April 2019 |
| | | | | US | 2018-0306868 | A1 | 25 October 2018 |
| | | | | WO | 2018-199434 | A1 | 01 November 2018 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020230159979